(19) Europäisches Patentamt
European Patent Office
Office européen des brevets

(11) **EP 1 324 500 A1**

(12) **DEMANDE DE BREVET EUROPEEN**

(43) Date de publication:
**02.07.2003 Bulletin 2003/27**

(51) Int Cl.⁷: **H03M 13/27**

(21) Numéro de dépôt: **02293185.1**

(22) Date de dépôt: **20.12.2002**

(84) Etats contractants désignés:
**AT BE BG CH CY CZ DE DK EE ES FI FR GB GR IE IT LI LU MC NL PT SE SI SK TR**
Etats d'extension désignés:
**AL LT LV MK RO**

(30) Priorité: **26.12.2001 FR 0116888**

(71) Demandeur: **Nortel Networks Limited**
**St. Laurent, Quebec H4S 2A9 (CA)**

(72) Inventeurs:
• **Boumendil, Sarah**
**75015 Paris (FR)**
• **Le Strat, Evelyne**
**75015 Paris (FR)**
• **Massie, Bastien**
**75012 Paris (FR)**

(74) Mandataire: **Loisel, Bertrand**
**Cabinet Plasseraud,**
**84, rue d'Amsterdam**
**75440 Paris Cédex 09 (FR)**

(54) **Méthode et appareil de communication numérique avec entrelacement variable**

(57)    On affecte les symboles numériques d'une séquence à des positions respectives dans des tranches temporelles successives, conformément à un format de tranche prédéterminé. Dans plusieurs des tranches temporelles, on remplace un symbole de la séquence par un symbole de substitution porteur d'une information supplémentaire. On émet sur un canal de communication un signal représentatif de la séquence de symboles répartie dans les tranches temporelles. La production de la séquence comporte un entrelacement ayant une période d'entrelacement plus longue qu'une tranche temporelle, généralement effectué après un codage de canal. On fait varier la position des symboles de substitution dans les tranches temporelles qui en comportent, afin d'optimiser les performances de la chaîne de transmission.

FIG.2.

EP 1 324 500 A1

## Description

La présente invention concerne les transmissions numériques et, plus précisément la mise en forme d'un ou plusieurs flux de symboles d'information à transmettre sur un ou plusieurs canaux de communication dans un système de communication supportant des mécanismes d'entrelacement des données.

Il est classique dans les systèmes de communication numériques de protéger l'information à transmettre contre les erreurs de transmission, au moyen de codes détecteurs et correcteurs d'erreurs. On sait que les algorithmes de décodage exécutés par les récepteurs ont des performances optimales lorsque les éventuelles erreurs sont dispersées dans le temps. Or les phénomènes introduisant des erreurs dans les données transmises sont souvent tels que les données erronées sont groupées en paquets d'erreurs. C'est le cas par exemple dans les canaux radio sujets au phénomène d'évanouissement. Les performances des algorithmes de détection et de correction d'erreurs sont alors fortement diminuées.

C'est pourquoi on utilise souvent des mécanismes d'entrelacement. Au niveau de l'émetteur, un entrelaceur permute les symboles d'information à transmettre sur un certain intervalle de temps (période d'entrelacement), le récepteur étant muni d'un désentrelaceur qui effectue la permutation inverse. Ainsi, si le flux de donnés transmis subit sur le canal de propagation une perturbation de durée donnée plus courte que la période d'entrelacement, les erreurs qui en résultent sur les symboles d'information sont dispersées à l'entrée du décodeur correcteur. Ceci a pour effet de limiter l'effet des erreurs sur les performances des algorithmes de détection et de correction, et donc sur la qualité perçue du service rendu.

L'invention se rapporte aux techniques de poinçonnage de symboles dans une séquence entrelacée à transmettre. Le poinçonnage consiste à choisir certains symboles (binaires ou plus généralement M-aires, avec M ≥2) afin de les enlever de la séquence à transmettre. La place ainsi libérée sur le canal physique utilisé pour transmettre la séquence entrelacée peut être utilisée pour transmettre une information spécifique telle qu'une information de signalisation. Dans ce cas, on profite d'un canal de communication donné pour y insérer des informations à la cadence souhaitée, sans qu'il soit nécessaire de définir d'autres ressources de transmission pour ces informations.

Un problème se pose toutefois lorsqu'on souhaite poinçonner plusieurs symboles d'information à intervalles réguliers à l'intérieur d'une période d'entrelacement. Etant donné le caractère déterministe et dispersif de l'opération d'entrelacement, si on poinçonne plusieurs symboles éparpillés sans précautions particulières, il est possible que la séquence de données correspondante avant entrelacement, et donc celle obtenue par le récepteur après désentrelacement, fasse apparaître un regroupement des symboles poinçonnés.

Or, chaque symbole poinçonné constitue une perte d'information pour le récepteur qui ne peut être compensée par les opérations de correction d'erreurs. Si plusieurs symboles poinçonnés sont regroupés après désentreiacement, la perte d'information devient importante et les performances du décodage sont fortement altérées. Cela contrevient au but premier de l'entrelacement. Il peut d'autre part en résulter un déséquilibre entre des canaux de transport multiplexés sur le canal physique de communication, dans le cas où le poinçonnage supprime, sur un canal physique, des symboles d'information issus d'un même canal de transport, tandis que d'autres canaux de transport ne subissent pas ou peu de poinçonnage étant donnée la position des symboles résultants de ces canaux de transport sur le canal physique après multiplexage.

Un but de la présente invention est d'améliorer cette situation en autorisant la transmission d'une information supplémentaire telle que par exemple une information de signalisation sur les canaux de communication entrelacés courants, sans pour autant dégrader les performances de la chaîne de transmission.

L'invention propose ainsi un procédé de communication numérique, comprenant les étapes suivantes :

- produire une séquence de symboles numériques ;
- affecter les symboles de la séquence à des positions respectives dans des tranches temporelles successives, conformément à un format de tranche prédéterminé ;
- dans plusieurs des tranches temporelles, remplacer au moins un symbole de la séquence par un symbole de substitution porteur d'une information supplémentaire ; et
- émettre sur un canal de communication un signal représentatif de la séquence de symboles répartie dans les tranches temporelles.

Selon l'invention, la production de la séquence comporte au moins un entrelacement ayant une période d'entrelacement plus longue qu'une tranche temporelle, et on fait varier la position des symboles de substitution dans les tranches où des symboles de la séquence sont remplacés.

La production de la séquence comporte généralement un codage de canal en amont de l'entrelacement. La variation de la position des symboles peut alors suivre un motif préalablement choisi de façon à ce que, dans la mesure du possible, les symboles codés correspondant, en sortie du codage de canal, aux symboles remplacés par les symboles de substitution ne soient pas groupés. Si le récepteur effectue des opérations inverses de celles qui ont lieu dans l'émetteur, notamment pour ce qui est de l'entrelacement, on évite ainsi le regroupement des symboles poinçonnés au sein du flux de données soumis au décodage de canal destiné à corriger les erreurs survenant sur le canal de communication.

Plusieurs entrelaceurs peuvent être utilisés et agir sur différentes périodes, au niveau d'un intervalle de transmission composé de plusieurs trames et au niveau d'une trame par exemple.

Dans une réalisation particulière, la production de la séquence comporte un entrelacement opéré à l'échelle des trames, et chaque trame comporte avant ledit entrelacement plusieurs groupes de symboles concaténés respectivement issus de canaux de transport différents multiplexés sur ledit canal de communication, chacun desdits canaux de transport ayant une période d'entrelacement respective composée d'un nombre entier de trames. La variation de position des symboles de substitution au sein d'une trame permet alors d'éviter que les symboles poinçonnés appartiennent de façon trop systématique aux mêmes canaux de transport.

L'information de signalisation transmise peut contenir une indication d'un ou plusieurs autres canaux de communication à lire pour un récepteur donné, alors que leur lecture est optionnelle en temps normal, ce qui a l'avantage d'économiser des ressources du récepteur en ne le sollicitant que lorsque des informations lui sont effectivement adressées.

Certains des symboles porteurs de l'information supplémentaire peuvent être émis avec une puissance d'émission supérieure aux autres symboles transmis, de manière à augmenter la fiabilité de leur réception, particulièrement lorsque ces symboles de substitution sont transmis sans redondance.

L'invention propose également un dispositif d'émission pour un système de communication numérique, comprenant :

- des moyens de production d'une séquence de symboles numériques ;
- des moyens d'affectation des symboles de la séquence à des positions respectives dans des tranches temporelles successives, conformément à un format de tranche prédéterminé ;
- des moyens de substitution pour remplacer, dans plusieurs des tranches temporelles, au moins un symbole de la séquence par un symbole de substitution porteur d'une information supplémentaire ; et
- des moyens d'émission, sur un canal de communication, d'un signal représentatif de la séquence de symboles répartie dans les tranches temporelles.

Les moyens de production de la séquence comportent au moins un entrelaceur ayant une période d'entrelacement plus longue qu'une tranche temporelle. Les moyens de substitution sont adaptés pour faire varier la position des symboles de substitution dans les tranches où des symboles de la séquence sont remplacés.

L'invention propose enfin un dispositif de réception pour un système de communication numérique, comprenant :

- des moyens de réception, sur un canal de communication, d'un signal représentatif d'une séquence de symboles numériques répartie dans des tranches temporelles successives ;
- des moyens d'extraction d'information supplémentaire d'une partie seulement des tranches temporelles, par lecture d'au moins un symbole respectif porteur d'une information supplémentaire dans chacune des tranches temporelles de ladite partie ; et
- des moyens de traitement de la séquence de symboles privée des symboles porteurs d'information supplémentaire, les symboles traités étant obtenus en des positions définies dans les tranches temporelles conformément à un format de tranche prédéterminé.

Les moyens de traitement de la séquence comportent au moins un désentrelaceur ayant une période de désentrelacement plus longue qu'une tranche temporelle. Les moyens d'extraction sont adaptés pour lire lesdits symboles porteurs d'information supplémentaire en des positions variables d'une tranche à une autre tranche dans ladite partie.

D'autres particularités et avantages de la présente invention apparaîtront dans la description ci-après d'exemples de réalisation non limitatifs, en référence aux dessins annexés, dans lesquels :

- la figure 1 est un schéma illustrant la structure de trame employée sur les liaisons descendantes dans le système UMTS en mode FDD ;
- les figures 2 et 3 sont des schémas synoptiques d'une station de base et d'un terminal UMTS auquel l'invention peut s'appliquer, dans le contexte de la fonctionnalité HSDPA ("High Speed Downlink Packet Access") ;
- les figures 4 et 5 sont des schémas synoptiques des blocs de multiplexage et de démultiplexage de la station de base et du terminal selon les figures 2 et 3 ;
- la figure 6 est un schéma simplifié indiquant le fonctionnement du premier entrelaceur dans un réseau radio UMTS ;
- la figure 7 est un schéma simplifié indiquant le fonctionnement du second entrelaceur dans un réseau radio UMTS ;
- la figure 8 est un exemple de poinçonnage mis en oeuvre par l'invention dans le contexte du HSDPA ;
- la figure 9 est un autre exemple de poinçonnage mis en oeuvre par l'invention dans le contexte du HSDPA.

Dans la présente description, l'invention sera décrite plus particulièrement dans son application, non limitative, aux réseaux de radiocommunication de troisième génération de type UMTS (« Universal Mobile Telecommunication System ») en mode FDD (« Frequency Division Duplex »).

L'UMTS est un système de radiocommunication utilisant un accès multiple à répartition par codes (CDMA, « Code-Division Multiple Access »), c'est-à-dire que les symboles transmis sont multipliés par des codes d'étalement constitués d'échantillons appelés « chips » dont la cadence (3,84 Mchip/s dans le cas de l'UMTS) est supérieure à celle des symboles transmis. Les codes d'étalement distinguent différents canaux physiques PhCH (« Physical CHannel ») qui sont superposés sur la même ressource de transmission constituée par une fréquence porteuse. Les propriétés d'auto- et d'intercorrélation des codes d'étalement permettent au récepteur de séparer les PhCH et d'extraire les symboles qui lui sont destinés. Pour l'UMTS en mode FDD sur la liaison descendante, un code de brouillage est alloué à chaque station de base, et différents canaux physiques utilisés par cette station de base sont distingués par des codes de « channelisation » mutuellement orthogonaux. Pour chaque PhCH, le code d'étalement global est le produit du code de « channelisation » et du code de brouillage de la station de base. Le facteur d'étalement (égal au rapport entre la cadence des chips et la cadence des symboles) est une puissance de 2 comprise entre 4 et 512. Ce facteur est choisi en fonction du débit de symboles à transmettre sur le PhCH.

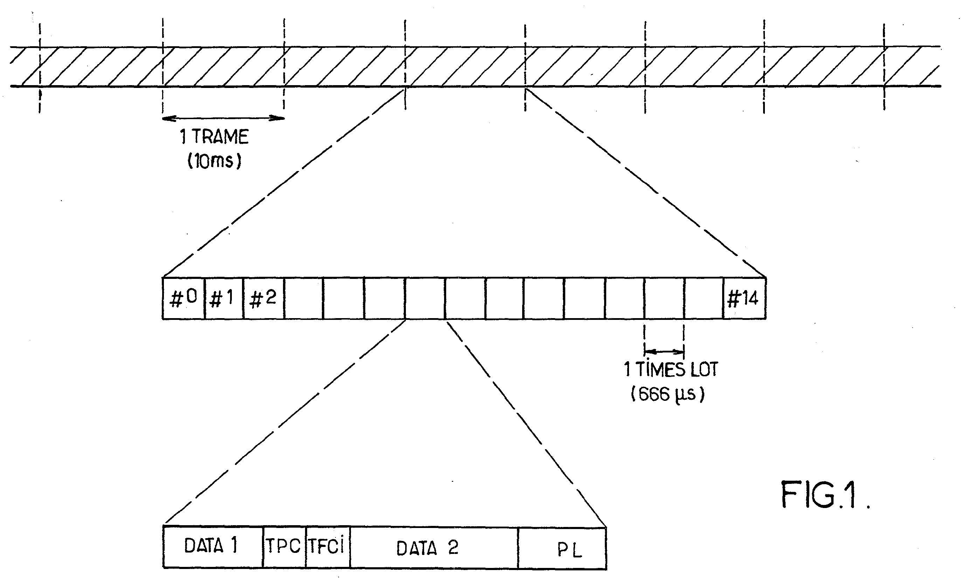

Les différents canaux physiques obéissent à une structure de trame illustrée par la figure 1. Les trames de 10 ms se succèdent sur la fréquence porteuse utilisée par la station de base. Chaque trame est subdivisée en N = 15 tranches temporelles (« timeslots ») de 666 µs. Chaque tranche peut porter les contributions superposées d'un ou plusieurs canaux physiques, comprenant des canaux communs et des canaux dédiés DPCH (« Dedicated Physical CHannel »). Le diagramme inférieur de la figure 1 illustre la contribution d'un DPCH descendant à une tranche temporelle en mode FDD, qui comporte :

- un certain nombre de symboles pilotes PL. Connus a priori du terminal, ces symboles PL lui permettent d'acquérir la synchronisation et d'estimer des paramètres utiles à la démodulation du signal ;

- une indication de combinaison de format de transport TFCI (« Transport Format Combination Indicator »);

- une commande de puissance d'émission TPC (« Transmit Power Control ») à utiliser par le terminal sur la liaison montante ; et

- deux champs de données, notés DATAI et DATA2, placés de part et d'autre du champ TPC.

Le DPCH peut ainsi être vu comme réunissant un canal physique dédié pour le contrôle, ou DPCCH (« Dedicated Physical Control CHannel »), correspondant aux champs TFCI, TPC et PL, et un canal physique dédié pour les données, ou DPDCH (« Dedicated Physical Data CHannel »), correspondant aux champs DATA1 et DATA2.

La modulation utilisée sur les canaux DPCH est une modulation de phase en quadrature (QPSK, « Quadrature Phase Shift Keying »). Les séquences de symboles soumises au modulateur sont donc composées de symboles quaternaires consistant chacun en l'assemblage de deux bits.

Il est possible, pour une même communication, d'établir plusieurs DPCH correspondant à des codes de « channelisation » différents, dont les facteurs d'étalement peuvent être égaux ou différents. Cette situation est notamment rencontrée lorsqu'un DPDCH ne suffit pas à fournir le débit de transmission requis par l'application. Dans la suite, on note Y le nombre, égal ou supérieur à 1, de canaux physiques descendants utilisés pour une même communication depuis une station de base.

Par ailleurs, cette même communication peut utiliser un ou plusieurs canaux de transport TrCH (« Transport CHannel »). Des TrCH multiplexés sont typiquement utilisés pour des transmissions multimédia, dans lesquelles des signaux de natures différentes à transmettre simultanément requièrent des caractéristiques de transport différentes, notamment en matière de protection contre les erreurs de transmission. D'autre part, certains codeurs peuvent délivrer, pour représenter un signal donné (par exemple audio), plusieurs flux de symboles ayant des importances perceptuelles différentes et requérant donc des degrés de protection différents. On utilise alors des TrCH multiples pour transporter ces différents flux de symboles. Dans la suite, on note X le nombre, égal ou supérieur à 1, de canaux de transport utilisés pour une communication donnée sur les Y canaux physiques précités.

Pour chaque canal de transport i ($1 \leq i \leq X$), il est défini un intervalle de temps de transmission TTI (« Transmission Time Interval ») composé de $F_i$ trames consécutives, avec $F_i$ = 1, 2, 4 ou 8. De façon typique, on utilise un TTI d'autant plus court que le signal véhiculé par le canal de transport doit être reçu avec un faible retard. Par exemple, un TTI de 20 ms ($F_i$ = 2) sera utilisé pour une application de téléphonie, tandis qu'un TTI de 80 ms ($F_i$ = 8) pourra être utilisé pour une application de transmission de données.

Le multiplexage des X flux de symboles d'information issus des TrCH sur les Y PhCH est décrit en détail dans la spécification technique 3G TS 25.212, « Multiplexing and channel coding (FDD), Release 1999 », version 3.7.0, publiée en septembre 2001 par le 3GPP (3rd Generation Partnership Project).

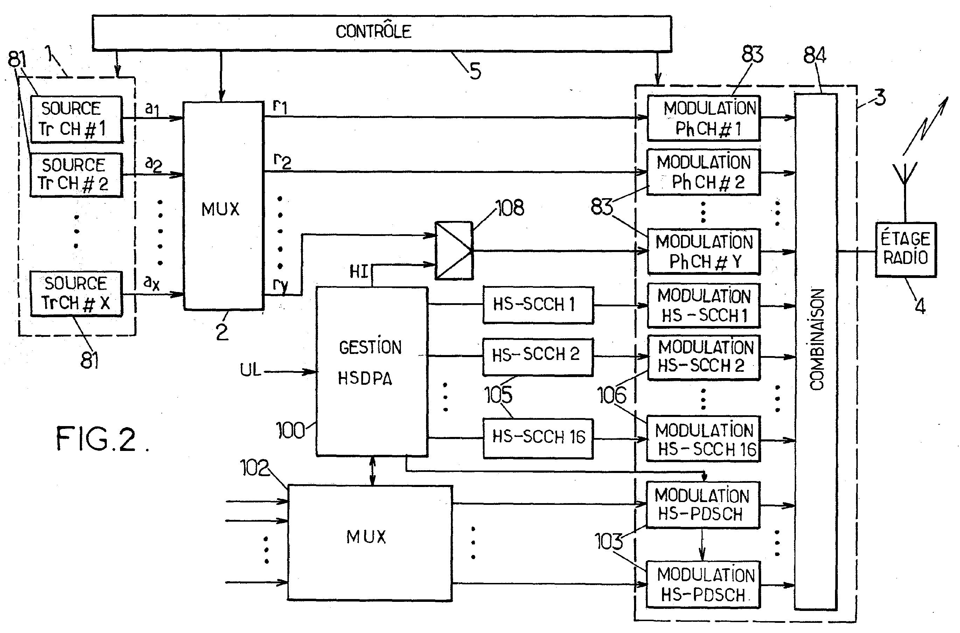

La figure 2 illustre schématiquement la partie émission d'une station de base UMTS fonctionnant en mode FDD. Le bloc 1 désigne l'ensemble des sources 81 délivrant respectivement des flux de symboles d'information $a_i$ ($1 \leq i \leq X$) relativement aux X TrCH utilisés dans une communication sur des ressources dédiées entre la station de base et un terminal.

Le bloc 2 multiplexe les flux $a_i$ pour former ce qu'on appelle un canal de transport composite codé, ou CCTrCH (« Coded Composite Transport CHannel »), qui est ensuite subdivisé en un ou plusieurs canaux physiques PhCH#j ($i \leq j \leq Y$) sur lesquels sont transmis des flux synchronisés de symboles respectivement notés $r_j$.

Le bloc 3 désigne les circuits qui modulent les flux $r_j$ et les combinent pour former un signal traité par l'étage radio 4 avant d'être émis sur l'interface air. Le bloc 3 assure l'étalement, par les codes de « channellisation » affectés aux PhCH, de chacun des flux $r_j$ (modules 83), ainsi que des flux supplémentaires éventuellement délivrés pour d'autres communications supportées au même moment par la station de base, les différents flux de symboles ainsi étalés étant ensuite sommés puis multipliés par le code de brouillage de la station de base (module 84). Le séquencement et le paramétrage des blocs 1,2,3 est assuré par une unité de contrôle 5 conformément aux paramètres définis pour la station de base et pour la communication considérée.

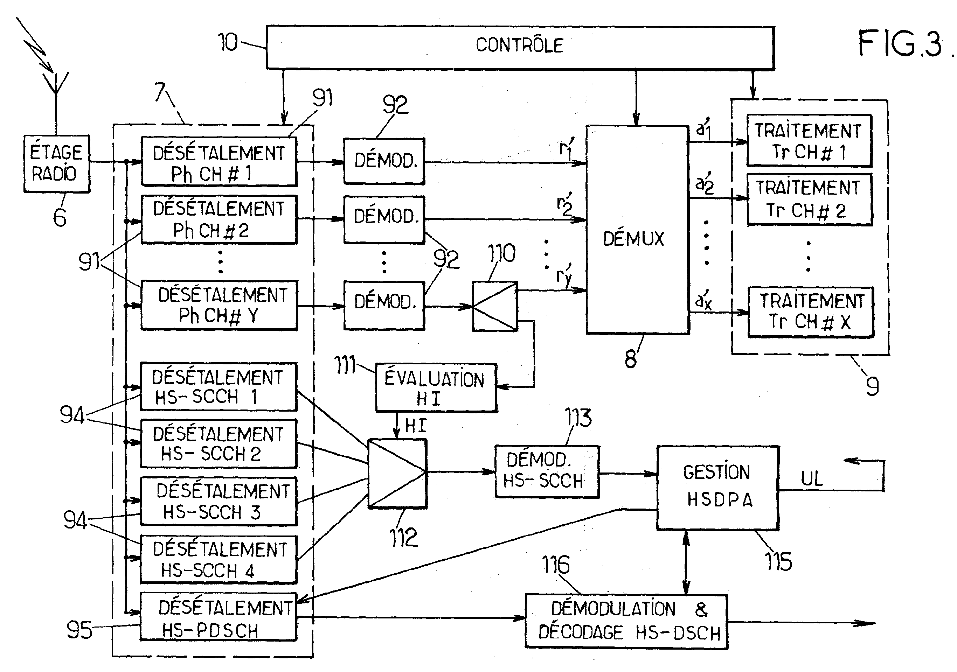

La figure 3 illustre schématiquement la partie réception d'un terminal UMTS communiquant en mode FDD avec une station de base selon la figure 2. Le bloc 7 comportent des modules 91 (filtres adaptés) pour désétaler le signal en bande de base restitué par l'étage radio 6 à partir du signal capté par l'antenne du terminal, en utilisant le code de brouillage de la station de base et les Y codes de « channelisation » respectifs affectés au terminal. Pour chacun des Y canaux physiques j ($i \leq j \leq Y$), un module 92 démodule le signal désétalé pour délivrer des données respectives $r'_j$ représentant des estimations des symboles du flux $r_j$ formé au niveau de la station de base.

Dans le cas où les symboles sont des bits, les estimations $r'_j$ sont des « softbits », c'est-à-dire des valeurs numériques dont le signe caractérise le bit estimé et la valeur absolue représente la vraisemblance de cette estimation.

Les Y flux de données $r'_j$ sont fournis à un bloc de démultiplexage 8 qui effectue les opérations inverses du multiplexeur 2 de la station de base. Ce bloc 8 délivre pour chaque canal de transport i ($1 \leq i \leq X$) un flux $a'_i$ d'estimations (softbits ou hardbits) des symboles du flux $a_i$. Ces estimations $a'_i$ sont fournies au circuit de traitement du TrCH i appartenant au bloc 9. Le séquencement et le paramétrage des blocs 7, 8, 9 est assuré par une unité de contrôle 10 du terminal.

Ainsi qu'il est usuel dans le domaine des radiocommunications numériques, les blocs 1-3, 5 de la station de base et 7-10 du terminal peuvent être réalisés en programmant un ou plusieurs processeurs de signal numérique, et/ou en utilisant des circuits logiques spécifiques.

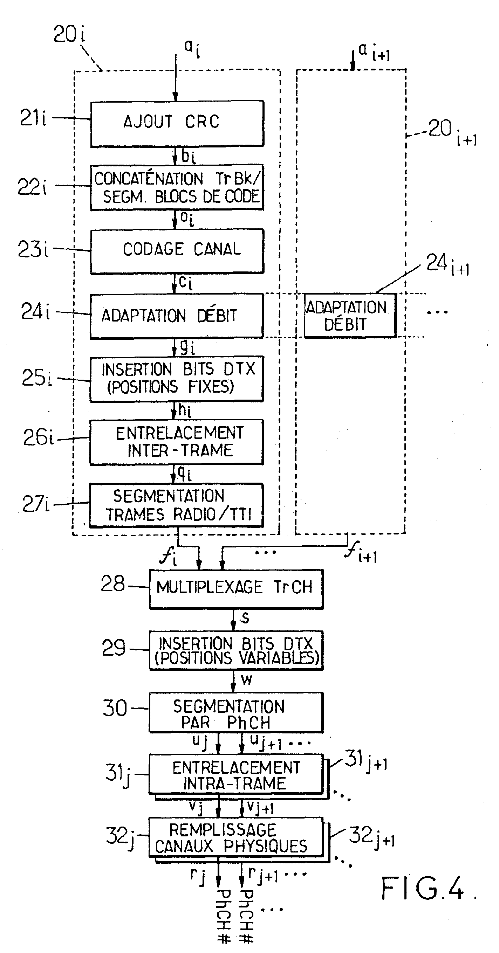

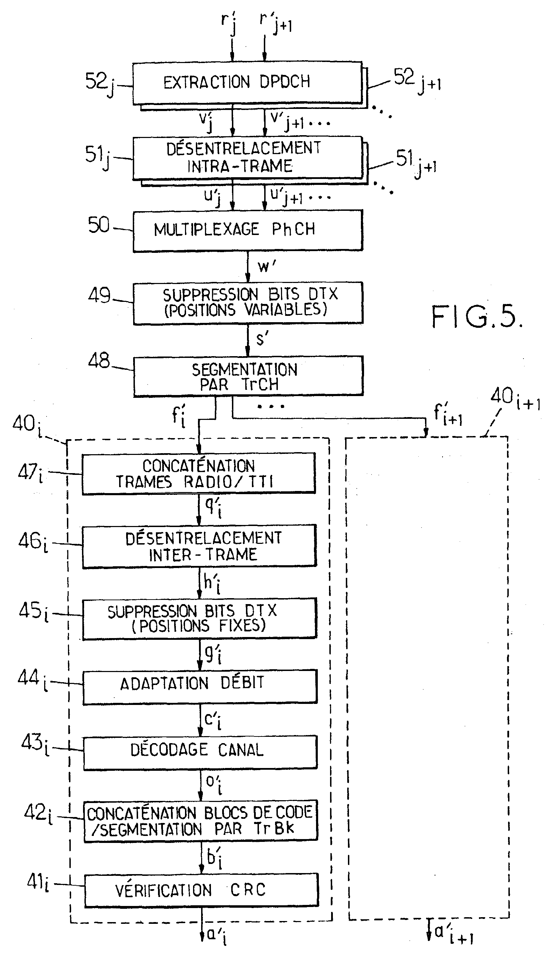

Les figures 4 et 5 détaillent respectivement les différents modules fonctionnels des blocs de multiplexage 2 et de démultiplexage 8 (voir la spécification 3G TS 25.212 précitée). Sur ces figures, les références portant l'indice i ($1 \leq i \leq X$) désignent les éléments se rapportant au TrCH i (blocs $20_i$ et $40_i$), les références portant l'indice j désignent les éléments se rapportant au PhCH j ($1 \leq j \leq Y$), et les références sans indice se rapportent aux opérations effectuées pour chaque trame au niveau CCTrCH.

Le flux $a_i$ à transmettre sur chaque TrCH i est composé de symboles binaires délivrés sous forme de blocs de transport successifs TrBk (« Transport Block»). Le module $21_i$ complète chaque TrBk en y ajoutant un code de redondance cyclique CRC, servant à détecter d'éventuelles erreurs de transmission. Les TrBk $b_i$ sont ensuite concaténés et/ou segmentés par le module $22_i$ pour former des blocs $o_i$ de taille appropriée pour l'entrée du codeur de canal $23_i$.

Pour chaque TTI du canal de transport i, le codeur de canal $23_i$ délivre une séquence $c_i$ de $E_i$ bits codés notés $c_{i,m}$ ($i \leq m \leq E_i$). Deux types de code correcteur d'erreurs peuvent être appliqués par le module $23_i$ :

- un code convolutif de rendement 1/2 ou 1/3 et de longueur de contrainte K = 9 ;
- un turbocode de rendement 1/3 pour les applications requérant les taux d'erreurs les plus faibles. Dans ce cas, les bits $c_{i,3p+q}$ de la séquence de sortie du codeur sont des bits systématiques (recopiés des blocs d'entrée $o_i$) si q = 1, et des bits de parité si q = 2 ou 0.

Les modules $24_i$ d'adaptation de débit (« rate matching ») suppriment (poinçonnent) ou répètent des bits des séquences $c_i$ afin d'adapter le débit binaire des TrCH au débit global admissible sur le ou les PhCH compte tenu de leurs facteurs d'étalement. Pour chaque TTI sur le TrCH i, il est défini, à partir des informations fournies par les couches supérieures de protocole, un paramètre $\Delta N_i^{TTI}$ négatif dans le cas du poinçonnage et positif dans le cas de la répétition. La séquence $g_i$ produite par le module $24_i$ pour le TTI est composée de $G_i = E_i + \Delta N_i^{TTI}$ bits notés $g_{i,n}$ ($1 \leq n \leq G_i$). Dans le cas où le module $23_i$ a utilisé un turbocode, le poinçonnage appliqué par le module $24_i$ si $\Delta N_i^{TTI} < 0$ est limité aux bits de parité compte tenu de l'importance plus grande des bits systématiques pour le décodeur.

Dans une trame donnée, les périodes consacrées aux différents TrCH de la communication peuvent avoir des positions fixes (avant l'entrelacement intra-trame évoqué ci-après) ou des positions variables. Dans le cas des positions fixes, il peut être nécessaire d'adjoindre à la séquence $g_i$, au moyen du module $25_i$, un ou plusieurs symboles marqués qui ne seront pas transmis (la valeur du bit correspondant sera par exemple mise à zéro au lieu de $\pm 1$ dans le flux de sortie $r_j$ comportant un tel symbole pour que la puissance d'émission du symbole soit nulle). On note « $\delta$ » les bits de DTX (« Discontinuous Transmission ») ainsi marqués. Dans l'exemple d'implémentation considéré ici de manière non limitative, chaque symbole $h_{i,n}$ de la séquence $h_i$

délivrée par le module $25_i$ ($0 \leq n \leq F_i.H_i$, avec $G_i \leq F_i.H_i$) est représenté par deux bits :

- $h_{i,n} = (0, g_{i,n})$ si $n \leq G_i$ ;

- $h_{i,n} = (1, 0)$ si $G_i < n \leq F_i.H_i$ (bits marqués « δ »).

Le module d'entrelacement $26_i$ effectue une permutation de la séquence $h_i$, en vue de distribuer les symboles relevant du TTI sur les $F_i$ trames qu'il couvre. Cet entrelacement inter-trame (si $F_i > 1$) consiste à écrire successivement les symboles de la séquence $h_i$ dans les lignes d'une matrice comportant $F_i$ colonnes, à permuter les colonnes de la matrice, puis à lire les symboles de la matrice colonne après colonne pour former la séquence notée $q_i$. Le module $27_i$ découpe ensuite la séquence $q_i$ en $F_i$ segments de symboles consécutifs correspondant aux $F_i$ colonnes de la matrice d'entrelacement après permutation, et affecte respectivement ces segments aux $F_i$ trames du TTI pour former une séquence notée $f_i$ pour chaque trame et chaque TrCH i ($i \leq i \leq X$).

Conformément à la spécification 3G TS 25.212, la permutation de colonnes effectuée par l'entrelaceur inter-trame $26_i$ est telle que le n-ième symbole $h_{i,n}$ du TTI, avec $n = (\alpha-1).F_i + \beta$, $\alpha$ et $\beta$ étant des entiers tels que $1 \leq \alpha \leq R1$ et $1 \leq \beta \leq F_i$, se retrouve à la $\alpha$-ième position dans la $\gamma$-ième trame du TTI, soit :

$$h_{i,n} = q_{i,n},$$

avec

$$n' = (\gamma-1).R1 + \alpha \qquad (1)$$

où R1 désigne le plus petit entier tel que $R1 \times F_i$ soit au moins égal au nombre $X_i$ de bits de la trame courante ($X_i \leq R1 \times F_i$), et $\gamma$ est un index de trame défini par l'entier $\beta$ d'après la permutation: $\gamma-1 = BR (n-1, F_i) = BR(\beta-1, F_i)$. Le nombre $BR(x, 2^y)$ est ici défini comme l'entier dont la représentation en base 2 correspond à la lecture en sens inverse de la représentation en base 2 sur y chiffres du reste de la division euclidienne de x par $2^y$ (par exemple, BR $(51, 8) = BR(3, 8) = BR([011]_2, 2^3) = [110]_2 = 6$).

Les séquences $f_i$ produites pour les différents TrCH de la communication ($1 \leq i \leq X$) sont multiplexées, c'est-à-dire placées les unes à la suite des autres, par un module 28 formant une séquence s de S symboles pour le CCTrCH. Dans le cas où les périodes consacrées aux différents TrCH de la communication ont des positions variables, il peut être nécessaire d'adjoindre à la séquence s, au moyen du module 29, un ou plusieurs symboles marqués « δ ». Dans l'exemple d'implémentation considéré ici, chaque symbole $w_k$ de la séquence

w délivrée par le module 29

$$\left(1 \leq k \leq \sum_{j=1}^{Y} U_j \right.,$$

avec

$$S \leq \sum_{i=1}^{Y} U_j$$

et $U_j$ égal au nombre de bits par trame sur le DPDCH du canal physique j, lequel nombre dépend du facteur d'étalement alloué au canal) est représenté par deux bits

- $w_k = (0, s_k)$ si $k \leq S$ ;

$$- \; w_k = (1, 0) \; \text{ si } \; S < k \leq \sum_{j=1}^{Y} U_j \; .$$

Le module 30 découpe ensuite la séquence w en Y segments de $U_1$, $U_2$, ..., $U_Y$ symboles consécutifs, et affecte respectivement ces segments aux Y PhCH pour former une séquence notée $u_j$ pour chaque PhCH j ($1 \leq j \leq Y$). Le module d'entrelacement $31_j$ effectue une permutation de la séquence $u_j$, en vue de distribuer les symboles, au sein de la trame courante, sur les Y PhCH employés par la communication. Cet entrelacement consiste à écrire successivement les symboles de la séquence $u_j$ dans les lignes d'une matrice comportant $C2 = 2 \times N = 30$ colonnes, à permuter les colonnes de la matrice, puis à lire les symboles de la matrice colonne après colonne pour former la séquence de $U_j$ symboles notée $V_j$.

Le module $32_j$ de remplissage du canal physique (« physical channel mapping ») distribue finalement les symboles successifs de la séquence $v_j$ dans les champs DATA1 et DATA2 des tranches temporelles de la trame courante. Le module $32_j$ peut traduire les bits d'information à valeurs 0 ou 1 en bits signés ($\pm$1), et affecter la valeur 0 aux bits marqués « δ ». Il complète en outre le flux $r_j$ adressé au bloc 3 en insérant les bits de signalisation adéquats dans les champs PL, TFCI et TPC du DPCCH.

Conformément à la spécification 3G TS 25.212, si on désigne par R2 le plus petit entier tel que $R2 \times C2$ soit au moins égal au nombre $U_j$ de bits de la trame courante ($U_j \leq R2 \times C2$), la permutation de colonnes effectuée par l'entrelaceur intra-trame $31_j$ est telle que le n-ième symbole $u_{j,n}$ de la trame courante, avec

n = ($\alpha$-1).C2 + $\beta$, $\alpha$ et $\beta$ étant des entiers tels que 1 $\leq \alpha$ $\leq$R2 et 1 $\leq \beta \leq$C2 = 2×N, se retrouve à la ($\epsilon$.R2+$\alpha$)-ième position dans une $\gamma$-ième tranche temporelle de la trame, soit

$$u_{j,n} = v_{j,n},$$

avec

$$n' = 2.(\gamma\text{-}1).R2 + \epsilon.R2 + \alpha \qquad (2)$$

où $\epsilon$ = 0 ou 1 et 2.($\gamma$-1) + $\epsilon$ est un entier obtenu en fonction de $\beta$-1 par une permutation déterminée $perm_{C2}$ sur les entiers compris entre 0 et C2-1: 2.($\gamma$-1) + $\epsilon$ = $perm_{C2}$ ($\beta$-1).

Le bloc de démultiplexage 8 du terminal comporte des modules qui effectuent, dans le sens inverse, les opérations duales des modules $20_i$-$32_j$ du bloc de multiplexage 2 de la station de base. Sur la figure 5, les références primées correspondent aux estimations des symboles portant les mêmes références non primées sur la figure 4. Pour les symboles composés de deux bits formatés comme indiqué ci-dessus en raison du marquage des bits « $\delta$ », ces estimations (softbits) se rapportent au bit de poids le plus faible.

Pour chaque trame de 10 ms et chaque PhCH, le module $52_j$ extrait des champs DATA1 et DATA2 du signal démodulé la séquence $v'_j$ de $U_j$ softbits relevant du DPDCH. Le module de désentrelacement $51_j$ applique à cette séquence $v'_j$ la permutation inverse du module $31_j$ pour restituer la séquence de softbits $u'_j$. Les Y séquences $u'_j$ sont mises bout à bout par le module de multiplexage 50 pour former la séquence de softbits w' relative au CCTrCH. Dans le cas où les TrCH sont à positions variables, le module 49 supprime les

$$\sum_{j=1}^{Y} U_j - S$$

derniers softbits de la séquence w', qui correspondent à des bits « $\delta$ ». La séquence de softbits s' produite par le module 49 est découpée par le module de segmentation 49 en X sous-séquences $f'_i$ respectivement affectées aux TrCH.

Pour chaque TrCH i dont le TTI comporte plusieurs trames ($F_i$ > 1), le module $47_i$ concatène les sous-séquences produites relativement aux différentes trames pour former la séquence $q'_i$ soumise au module de désentrelacement inter-trame $46_i$. Celui-ci opère la permutation inverse du module $26_i$ pour restituer la séquence de softbits $h'_i$. Dans le cas où les TrCH sont à positions fixes, le module $45_i$ supprime les $F_i.H_i - G_i$ derniers softbits de la séquence $h'_i$, qui correspondent à des bits « $\delta$ ». La séquence de softbits s' produite par le module 49 est ensuite traitée par le module d'adaptation de débit $44_i$ qui effectue les opérations suivantes :

- insertion d'un softbit nul (vraisemblance minimale) à la place de chaque bit qui a été poinçonné à l'émission ;
- réévaluation de chaque softbit correspondant à un bit qui a été répété à l'émission, afin d'en affiner la vraisemblance.

La séquence de sortie $c'_i$ du module $44_i$ est décodée par le module $43_i$ afin de corriger d'éventuelles erreurs de transmission. Les symboles des blocs décodés $o'_i$ délivrés par le module $43_i$ peuvent être des softbits, ou des hardbits si les mesures de vraisemblance ne sont plus nécessaires dans les traitements ultérieurs. A partir de ces blocs $o'_i$, le module $42_i$ reconstitue les TrBk estimés $b'_i$, et le module $41_i$ vérifie l'intégrité du CRC pour valider ces TrBk dans le flux de sortie $a'_i$ relatif au TrCH i.

On se place désormais dans un mode de réalisation particulier et non restrictif de l'invention lié à la fonctionnalité HSDPA (« High Speed Downlink Packet Access »). Une description d'ensemble de cette fonctionnalité peut être trouvée dans la spécification technique TS 25.308, Release 5, version 5.0.0, publiée en septembre 2001 par le 3GPP.

Le HSDPA permet la transmission par une station de base de données à haut débit pour un ensemble de stations mobiles situées dans la zone de couverture de la station de base. Il s'appuie sur un canal de transport descendant partagé à haut débit : le HS-DSCH (« High Speed - Downlink Shared Channel »). Dans le mode FDD auquel on s'intéresse plus particulièrement dans la présente description, ce canal a notamment pour caractéristiques : (i) un intervalle de temps de transmission (TTI) de 2 millisecondes correspondant à 3 tranches temporelles de 666 $\mu$s ; (ii) des processus hybrides de requête de retransmission des données de type HARQ (« Hybrid Automatic Repeat reQuest ») ; et (iii) un mécanisme adaptatif de codage et de modulation. Au niveau du réseau d'accès, une couche spécifique du protocole de contrôle d'accès au médium (MAC, « Medium Access Control »), est localisée dans la station de base. Ainsi, on fait en sorte d'offrir un débit maximum sur ce canal. Pour la même raison, le HS-DSCH utilise un facteur d'étalement relativement faible, égal à 16. Dans une cellule donnée et pour un code de brouillage donné, il peut être établi jusqu'à 15 canaux HS-DSCH utilisant des codes de « channelisation » orthogonaux.

Pour un canal HS-DSCH, il doit être prévu un ou plusieurs canaux physiques de contrôle partagés spécifiques appelés HS-SCCH (« High Speed - Shared Control CHannel ») ou SCCH-HS. Les informations de signalisation portées par les HS-SCCH identifient les terminaux destinataires des blocs transmis sur les HS-DSCH, et leur fournissent un certain nombre d'indications utiles à la réception de ces blocs :

- un indicateur de format de transport et de ressources (TFRI, « Transport Format and Resource Indicator »), donnant les informations concernant le format de la partie dynamique du canal HS-DSCH, notamment pour le schéma de modulation employé, et les ressources physiques allouées (codes de « channelisation ») ;
- les informations liées au protocole HARQ, notamment la version de redondance, un identifiant de processus HARQ, et un indicateur de nouveaux blocs de données.

Un canal HS-SCCH utilise un facteur d'étalement de 128, avec un TTI identique à celui du HS-DSCH (3 tranches de 666 µs). Tous les HS-PDSCH (c'est-à-dire les canaux physiques issus des HS-DSCH) au sein d'une cellule sont alignés en temps et la synchronisation des HS-SCCH est avancée de deux tranches (1333 µs) par rapport à celle des HS-PDSCH associés, ce qui permet au terminal destinataire d'un bloc de données transmis sur un HS-PDSCH dans un TTI HSDPA de 2 ms de connaître les informations nécessaires à sa réception. Certaines informations contenues dans le TFRI, à savoir les codes alloués ainsi que la modulation utilisée, sont primordiales pour les terminaux car elles leur permettent de commencer à démoduler le ou les HS-PDSCH qui les concernent. C'est pourquoi le TFRI est inclus dans la première tranche de chaque TTI sur le HS-SCCH. Ainsi, un décodage rapide du HS-SCCH permet à un terminal de lire le contenu du HS-PDSCH dans le prochain TTI sans perte d'information.

Les informations de contre-réaction retournées par le terminal, notamment pour les acquittements du protocole HARQ et pour les mesures utiles à la modulation adaptative, sont transmises par une ressource montante dédiée, sur un canal nommé DPCCH-HS (« Dedicated Physical Control Channel - High Speed »).

A l'établissement des HS-DSCH et HS-SCCH, le contrôleur de réseau radio (RNC, « Radio Network Controller ») qui supervise la station de base lui alloue les ressources de code correspondantes, par cellule. A titre d'exemple, on peut prévoir de réserver jusqu'à 16 codes de facteur d'étalement 128 pour les HS-SCCH.

Lorsqu'une session HSDPA est ouverte pour un terminal donné, le RNC lui indique, ainsi qu'à la station de base, un certain nombre de codes HS-SCCH sur lesquels les informations de signalisation qui le concernent sont susceptibles de lui être envoyées. Ce nombre de codes HS-SCCH est compris entre 1 et 4 pour chaque terminal. On considèrera ci-après qu'il est égal à 4, sans restreindre la généralité de l'exposé.

Dans une réalisation typique, un terminal opère en permanence le désétalement du signal reçu au moyen des 4 codes HS-SCCH qui lui ont été indiqués. Toutefois, pour éviter de solliciter inutilement les ressources du terminal, il est judicieux que celui-ci ne décode que le HS-SCCH qui le concerne le cas échéant. Pour cela, on prévoit une signalisation spécifique sur la voie descendante, empruntant un canal dédié (DPCH) fonctionnant en parallèle avec le HS-PDSCH pour ce terminal.

Cette signalisation spécifique comporte un indicateur de deux bits appelé HI (« HS-DSCH Indicator »), porté par le DPCH et indiquant au terminal que des informations lui sont destinées sur un HS-SCCH identifié. Les deux bis du HI définissent quatre états qui permettent de distinguer lequel des quatre HS-SCCH porte le cas échéant de l'information concernant le terminal. Si le HI est transmis avec une puissance nulle (ce qui constitue un cinquième état), aucun des quatre HS-SCCH ne porte d'information concernant le terminal. Dans ce dernier cas, le terminal peut attribuer une valeur au HI qui le conduit à décoder pour rien un HS-SCCH, mais il s'en aperçoit rapidement car le HS-SCCH indique aussi le terminal destinataire.

Le HI destiné à un terminal doit être transmis, lu et interprété par ce terminal avant la fin de la première tranche du HS-SCCH, afin qu'il dispose à temps des informations du TFRI (code HS-DSCH alloué et modulation utilisée) qui sont nécessaires pour pouvoir démoduler un HS-PDSCH le cas échéant.

Un problème que pose l'insertion du HI dans le flux transmis sur le DPCH est que sa cadence de transmission est élevée et que sa récupération par le terminal doit être très rapide. Il est nécessaire d'en prévoir 5 transmissions par trame, soit $5 \times F_i$ transmissions par TTI d'un canal de transport dédié correspondant à ce DPCH, et le terminal ne peut pas attendre d'avoir reçu un TTI complet à décoder avant de connaître les valeurs de ces HI. En conséquence, le HI doit être inséré par exemple après poinçonnage, ou vol, de symboles QPSK en aval du second entrelaceur $30_j$. Ainsi, les deux bits d'un HI forment un symbole QPSK substitué, en entrée du modulateur, à un symbole de la séquence à transmettre. Cette substitution n'a lieu que dans certaines tranches seulement de la trame.

De retour à la figure 2, le module 100 a pour fonction de gérer la fonctionnalité HSDPA dans la station de base. Il intègre notamment l'instance du protocole MAC utile à la supervision du mode HSDPA. Ce module contrôle le multiplexage temporel des flux de transport pour les canaux HS-DSCH de la cellule, qui est réalisé, à raison d'un flux par terminal et par TTI sur un code donné, à partir des flux d'information reçus du RNC par le module de multiplexage 102 représenté sur la figure 2. Les signaux émis sur le ou les canaux physiques correspondants HS-PDSCH sont étalés et modulés dans le bloc 3, en appliquant le cas échéant le schéma de modulation adaptative spécifié (modules 103), puis combinés par le module 84 avec ceux des autres canaux physiques pour être transmis à l'étage radio 4 et émis sur la voie radio, comme exposé précédemment.

Le module de gestion HSDPA 100 prend en compte les informations de contre-réaction UL retournées par les terminaux sur la voie montante pour organiser la planification des blocs HARQ ainsi que l'adaptation de la modulation pour chaque TTI du HS-DSCH. Le module 100 contrôle en outre l'émission sur les canaux de transport HS-SCCH, qui sont au nombre de 16 pour une cellule gérée par la station de base dans l'exemple dessiné. Les signaux correspondants sont codés par les modules 105 à partir des informations spécifiées par le module 100 (identification des terminaux, TFRI, informations de HARQ, etc.). Ces signaux sont étalés et modulés dans le bloc 3 (modules 106), puis combinés par le module 84 avec ceux des autres canaux physiques.

Le module de gestion HSDPA 100 contrôle aussi la transmission du HI par vol de symboles sur les flux de symboles QPSK fournis aux modulateurs des DPCH, avant que ceux-ci soient modulés dans le bloc 3. Le HI est inséré au moyen d'un multiplexeur 108 placé en aval du bloc de multiplexage 2, précédemment décrit en référence à la figure 4, sur le flux de symboles relatif à un PhCH utilisé par le terminal.

Pour chaque utilisateur auquel un bloc HSDPA est destiné, le module 100 sélectionne :

(1) un code HS-PDSCH et un TTI prochainement disponible sur ce code pour recevoir le bloc ;
(2) un code HS-SCCH, parmi les quatre possibles pour l'utilisateur, ayant un TTI disponible avec deux tranches d'avance sur le TTI des canaux HS-PDSCH et donc en particulier de celui sélectionné à l'étape (1).

Le module 100 détermine alors les informations à transmettre dans le TTI disponible sur le HS-SCCH choisi, et commande en conséquence le module 105 correspondant. Il positionne enfin le HI en fonction du code HS-SCCH sélectionné à l'étape (2) et fait insérer ce HI dans les symboles transmis sur le canal dédié, avec une avance juste suffisante par rapport au TTI du canal HS-SCCH (par exemple au plus une tranche avant).

La partie inférieure de la figure 3 montre les opérations inverses effectuées dans un terminal récepteur. En sortie du démodulateur 92 fonctionnant sur le PhCH sur lequel le HI est inséré, un démultiplexeur 110 extrait le symbole QPSK correspondant au HI aux instants appropriés et le fournit à un module d'évaluation 111. Celui-ci commande en fonction de la valeur du HI un sélecteur 112 afin de sélectionner l'un des quatre flux de sortie des modules de désétalement 94 du bloc 7 auxquels ont été alloués les codes des quatre HS-SCCH indiqués par le RNC pour le terminal. Seul le flux sélectionné est alors démodulé et décodé par le module 113 afin d'obtenir les informations de signalisation transportées par le HS-SCCH. Ces informations de signalisation sont fournies à un module 115 de gestion du mode HSDPA dans le terminal, qui en déduit les paramètres nécessaires au fonctionnement :

- du ou des modules de désétalement 95 du bloc 7 auxquels sont alloués les codes HS-DSCH signalés sur le HS-SCCH ;
- du module de démodulation et de décodage 116 qui reçoit le flux de symboles désétalés correspondant et qui applique le traitement de réception approprié en fournissant les informations de contre-réaction requises (acquittement, ...).

Le module de gestion HSDPA 115 élabore les signaux UL à retourner sur le DPCCH montant à la station de base de la cellule à partir des informations de contre-réaction obtenues par le module 116.

Un vol de bits à une position fixe toutes les trois tranches pour y insérer le symbole contenant le HI peut poser un problème de dégradation du signal porté par le canal DPCH après décodage par le terminal. Les deux étapes de désentralecement $51_j$, $46_i$ effectuées dans le terminal modifient la position des symboles $r'_j$ reçus de telle sorte que des bits éloignés les uns des autres dans les tranches transmises peuvent se retrouver regroupés après désentrelacement. Ce regroupement fait qu'on risque d'avoir poinçonné plusieurs bits d'information consécutifs (jusqu'à 4 bits), et entraîne donc une dégradation significative des performances du décodage de canal $43_i$.

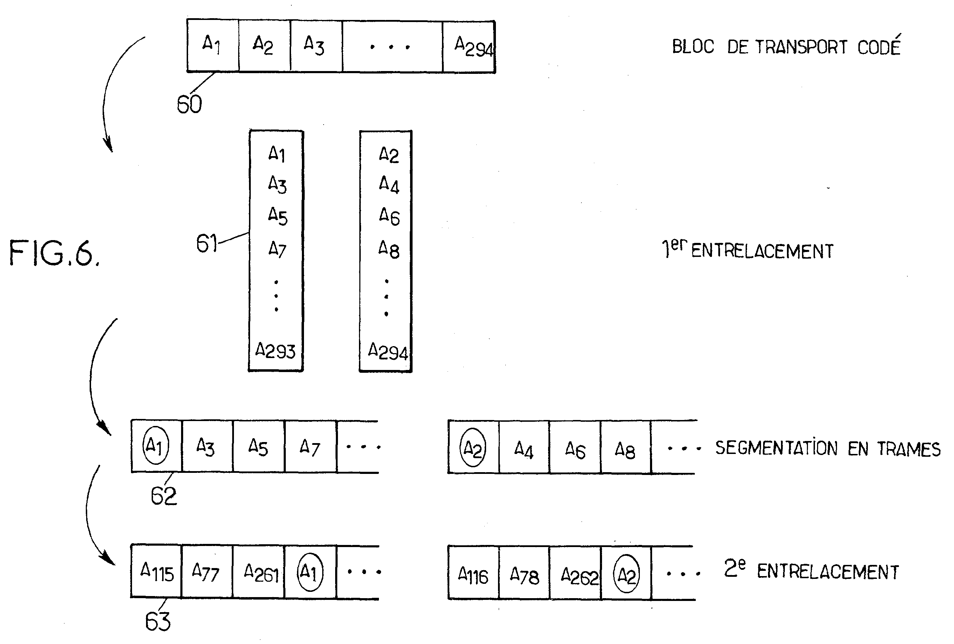

La figure 6 montre un exemple de bloc de transport 60 contenant 294 bits, notés $A_1$, $A_2$, $A_3$, ..., $A_{294}$, après codage de canal $23_i$ et adaptation de débit $24_i$. Conformément à ce qui a été décrit précédemment, le module d'entrelacement $26_i$ dans la station de base effectue une opération d'entrelacement sur ce bloc de transport 60. Elle revient à écrire par rangées dans une matrice à deux colonnes 61 la séquence de bits du bloc de transport 60. Le choix du nombre de colonnes (deux dans le présent cas) est fonction du TTI du bloc de transport 60. Dans l'exemple exposé, on considère un TTI de 20 millisecondes, de sorte que le bloc de transport 60 sera divisé en deux lors de la mise en trames du flux de bits transmis ($F_i = 2$). L'entrelacement opéré par le module $26_i$ consiste alors à lire la séquence de bits initiale dans l'ordre des colonnes de la matrice 61 en commençant par la seconde colonne.

Lors de la segmentation des trames radio effectuée par le module $27_i$, on obtient alors des trames 62 telles que représentées sur la figure 6. La première trame du TTI contient les bits impairs de la séquence de bits initiale du bloc de transport 60, tandis que la seconde trame contient les bits pairs de cette séquence de bits. Il est donc apparent sur cette figure que des bits initialement voisins de la séquence contenue dans le bloc 60, tels que $A_1$ et $A_2$, se retrouvent, après la segmentation en trames, en des positions identiques dans chacune des deux trames constituées. Ensuite, la permutation appliquée par le second entrelaceur $31_j$ est la même pour chaque trame (indépendamment des détails de cette permutation), de sorte que les deux symboles consécutifs $A_1$, $A_2$ se retrouveront de nouveau en des positions identiques après ce second entrelaceur $31_j$ (trames 63 sur la figure 6) : il feront alors partie de symboles QPSK de même rang dans deux trames radio consécutives. Si le symbole QPSK ayant ce rang est perdu du fait de l'insertion d'un HI dans la première trame, il en sera de même de celui ayant le même rang dans la trame suivante en raison du poinçonnage effectué à une position fixe 15 tranches plus tard, soit avec un décalage 5 TTI du HS-SCCH. On voit alors qu'aucun des deux symboles consécutifs $A_1$, $A_2$ ne sera reçu par le terminal, ce qui diminue les performances du décodeur.

La figure 6 montre donc que, lorsque $F_i > 1$, les caractéristiques du premier entrelaceur $26_i$ font que la substitution du HI en des positions fixes dans les tranches dégrade la réception des informations sur le canal dédié.

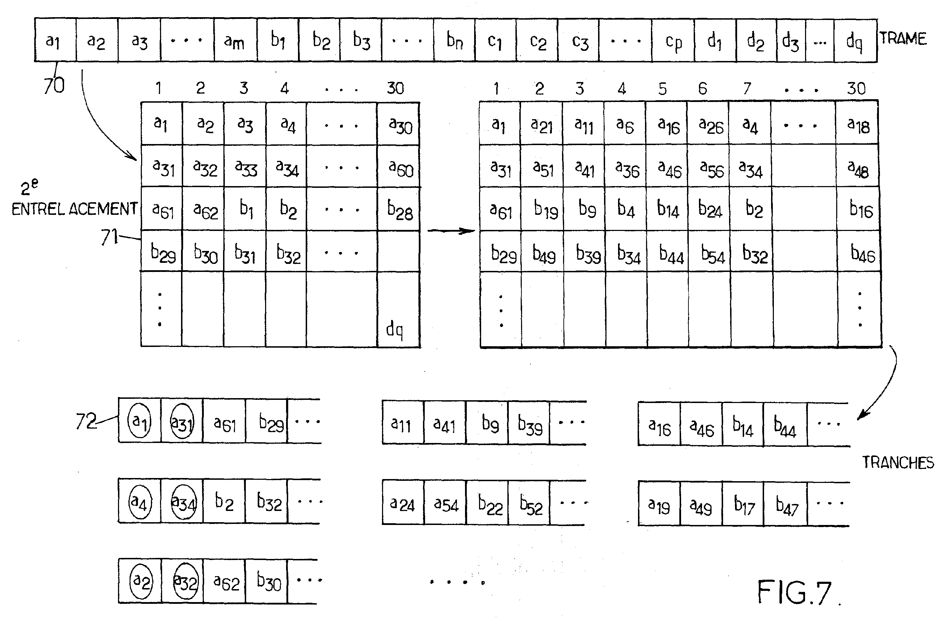

La figure 7 illustre quant à elle la structure du second entrelaceur $31_j$. La figure 7 présente une trame 70 à émettre sur un canal DPCH, constituée de bits d'information après multiplexage des canaux de transport (et segmentation par PhCH si Y > 1). Cette trame 70 est composée plusieurs groupes de bits, respectivement issus de canaux de transport (TrCH) différents, concaténés par le module 28 de la figure 4. Ces TrCH correspondent par exemple à des catégories de bits d'importance variable, issus d'un codeur de parole de type AMR (« Adaptive Multi-Rate »). On peut ainsi distinguer un premier groupe de bits $a_1$, $a_2$, $a_3$, ..., $a_m$ relevant d'un TrCH A, un second $b_1$, $b_2$, $b_3$, ..., $b_n$ relevant d'un TrCH B, un troisième groupe de bits $c_1$, $c_2$, $c_3$, ..., $c_p$ relevant d'un TrCH C, et un quatrième groupe de bits $d_1$, $d_2$, $d_3$, ..., $d_q$ relevant d'un TrCH D. La succession de ces groupes de bits résulte du multiplexage des canaux de transport par le module 28 à l'intérieur d'une trame de 10 millisecondes.

L'entrelacement intra-trame opéré par le module $31_j$ revient à écrire les bits de la trame 70 par rangées dans une matrice 71 de C2 = 30 colonnes. Le module $31_j$ lit ensuite la matrice 71, colonne par colonne, après permutation des 30 colonnes de cette matrice. Le flux de bits résultant est ensuite positionné dans les tranches à transmettre sur les canaux physiques, à raison de deux bits par symbole QPSK. Comme le nombre de colonnes de la matrice 71 (C2 = 30) est le double du nombre de tranches par trame (N = 15), les symboles d'une tranche correspondent à deux colonnes adjacentes de la matrice après permutation des colonnes. La partie inférieure de la figure 7 montre le contenu des sept premières tranches 72 de la trame dans un cas où on a m = 62 bits dans le TrCH A. Si on poinçonne un symbole QPSK de même position tous les trois tranches (par exemple le premier symbole correspondant aux deux premiers bits entourés à la partie inférieure de la figure 7), on voit qu'on tombe presque toujours dans les bits issus du même TrCH, à savoir le TrCH A dans l'exemple dessiné, duquel les bits $a_1$, $a_{31}$, $a_4$, $a_{34}$, $a_2$, $a_{32}$, $a_5$, $a_{35}$, $a_{13}$, $a_{43}$ seront perdus.

La figure 7 montre donc que les tranches ainsi constituées ne permettent pas de distribuer de façon aléatoire les bits en fonction de leur TrCH d'origine. Il en résulte un déséquilibre de traitement considérable entre les TrCH, qui ne peut que dégrader la qualité de service.

De plus, dans le ou les TrCH ainsi défavorisés, la probabilité de poinçonner deux bits voisins dans le flux de sortie du codeur de canal $23_i$ est augmentée. Cet effet négatif est accentué par celui mis en évidence par l'illustration de la figure 6 lorsqu'il y a plusieurs trames dans le TTI.

Pour pallier ces inconvénients, on fait varier d'une tranche à une autre la position des symboles poinçonnés et remplacés par des HI. Il en résulte :

- une meilleure répartition des bits poinçonnés entre les TrCH lorsque le PhCH comporte des contributions de plusieurs TrCH (cf. figure 7) ;
- une meilleure répartition des bits poinçonnés dans le flux de sortie du codeur de canal $23_i$ lorsqu'il y a plusieurs trames par TTI, c'est-à-dire lorsque $F_i > 1$ (cf. figure 6).

De très nombreux choix de position variable des bits poinçonnés dans les trames et les tranches peuvent être faits pour répondre à ces critères. Deux exemples non limitatifs sont présentés ci-après.

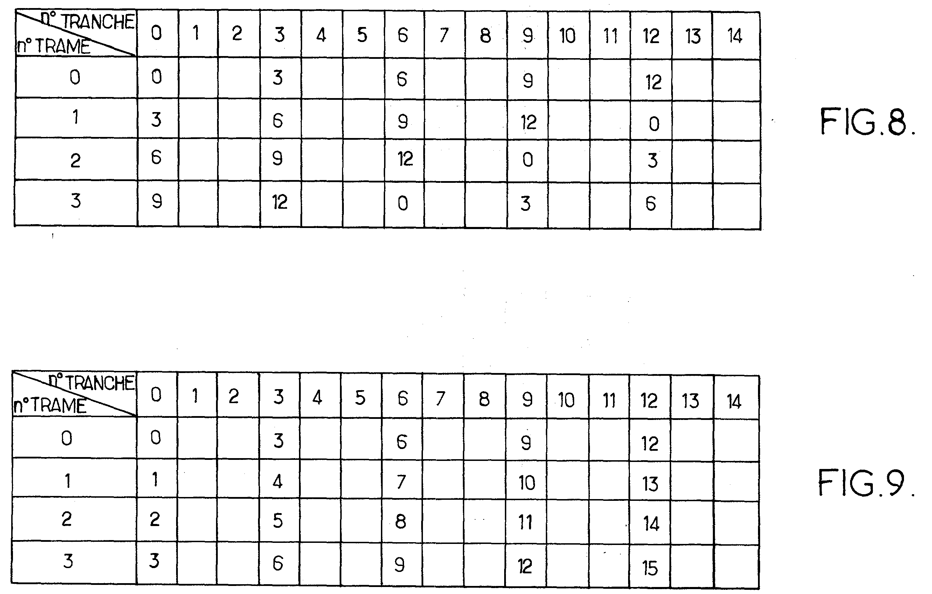

La figure 8 montre un exemple d'une telle fonction de distribution des symboles volés dans le cas d'un TTI de 40 ms ($F_i = 4$). Elle représente un tableau indiquant, pour les quatre trames de données indexées de 0 à 3, le numéro du symbole QPSK volé dans chaque tranche émise par la station de base. Dans cet exemple, les positions des cinq symboles volés sont les mêmes d'une trame à l'autre, mais ne sont pas appliquées aux mêmes tranches. C'est ainsi que les symboles volés dans la première trame ont respectivement les positions 0, 3, 6, 9 et 12 dans les tranches numérotées 0, 3, 6, 9 et 12. Ceci évite le problème évoqué ci-dessus en référence à la figure 7 relativement au déséquilibre de traitement des TrCH multiplexés. Pour la trame suivante, on applique une permutation circulaire à ces positions de symboles, de sorte que les symboles de positions 3, 6, 9, 12 et 0 sont respectivement volés dans les tranches numérotées 0, 3, 6, 9 et 12. La même permutation circulaire set appliquée pour déterminer les positions de poinçonnage dans les trames suivantes. Cette permutation circulaire évite le problème évoqué ci-dessus en référence à la figure 6 relativement aux dégradations de performances du décodeur de canal dues au premier entrelaceur lorsque $F_i > 1$. Dans les tranches intermédiaires numérotées 1, 2, 4, 5, 7, 8, 10, 11, 13 et 14, aucun symbole QPSK n'est volé dans cet exemple. Ceci s'explique, dans le cas d'application d'un vol de symbole pour transmettre au terminal mobile l'indicateur HI, par le fait que cet indicateur doit être transmis sur un symbole QPSK (soit deux bits d'information) toutes les trois tranches du canal DPCH qui le porte, conformément à ce qui a été décrit plus haut. La position des symboles volés suit le même schéma que pour les quatre premières trames représentées, pour les quatre trames suivantes.

La figure 9 présente un autre exemple de fonction autorisant une distribution des symboles de données volés qui ne dégrade pas de façon significative le démultiplexage et le décodage des données à la réception par le terminal mobile. Dans ce deuxième exemple de fonction, la position des symboles volés n'est plus conservée d'une trame à l'autre, mais est translatée d'un symbole pour chaque tranche. Ainsi, les positions des symboles QPSK volés pour insérer l'indicateur HI, portent les numéros 0, 3, 6, 9 et 12, respectivement dans les tranches 0, 3, 6, 9 et 12 de la première trame, comme dans l'exemple de la figure 8. Les symboles volés dans les mêmes tranches de la trame suivante ont pour position 1, 4, 7, 10 et 13 et ainsi de suite si $F_i > 2$.

Il est à noter que toute autre distribution des positions permettant de choisir les symboles d'information auxquels on vient substituer une information spécifique, telle que l'indicateur HI, présentera généralement des avantages par rapport à une solution "fixe" consistant à choisir toujours les mêmes positions de symboles dans les mêmes tranches pour chacune des trames contenant les informations transmises. Les exemples précédents ne sont donc pas exhaustifs. Pour ce qui est des exemples schématisés sur les figures 8 et 9, des simulations ont montré que la dégradation apportée par le vol de symboles d'information, notamment sur le taux d'erreur binaire observé au niveau de la réception, est quasiment annulée par l'utilisation d'une telle répartition des positions des symboles poinçonnés.

En pratique, le motif selon lequel on fait varier la position du HI dans les tranches successives qui l'incluent peut être un motif prédéterminé, tel que celui illustré par la figure 8 ou 9, enregistré une fois pour toutes dans l'émetteur et le récepteur. On peut aussi prévoir plusieurs motifs possibles, par exemple adaptés à différentes configurations de multiplexage des X TrCH sur les Y PhCH, et sélectionner l'un de ces motifs en fonction de la configuration rencontrée. L'information sur le motif retenu est alors transmise au terminal sur un canal de signalisation.

De préférence, le ou les symboles QPSK correspondant au HI, distribués avec des positions variables entre les tranches temporelles, sont émis par la station de base avec une puissance d'émission plus importante que les autres symboles d'information $r_j$, sauf lorsqu'aucun HS-SCCH ne concerne le terminal destinataire du canal dédié (auquel cas ces symboles sont émis avec une puissance nulle). Dans ce cas, le terminal destinataire peut lire ces symboles de façon fiable avant de décoder les flux d'information reçus, en limitant le risque d'obtenir une information erronée.

Bien sûr, l'invention ne se limite pas aux cas d'application décrits précédemment à titre d'illustration.

En particulier, des informations supplémentaires autres que l'indicateur HI peuvent être transmises au moyen du mécanisme de vol de symboles à positions variables qui a été décrit et qui permet de minimiser les dégradations engendrées dans les performances du récepteur. A titre d'exemple, on peut citer le cas d'un champ de données de type TPC (« Transmit Power Control ») utilisable pour asservir la puissance d'émission du terminal sur le canal de signalisation montant DPCCH-HS servant à retourner à la station de base la signalisation requise par un canal HS-PDSCH.

Le procédé selon l'invention est d'autre part applicable à des systèmes autres que le HSDPA ou l'UMTS.

## Revendications

1. Procédé de communication numérique, comprenant les étapes suivantes :

   - produire une séquence de symboles numériques ($r_j$);
   - affecter les symboles de la séquence à des positions respectives dans des tranches temporelles successives, conformément à un format de tranche prédéterminé ;
   - dans plusieurs des tranches temporelles, remplacer au moins un symbole de la séquence par un symbole de substitution porteur d'une information supplémentaire ; et
   - émettre sur un canal de communication un signal représentatif de la séquence de symboles répartie dans les tranches temporelles,

   dans lequel la production de la séquence comporte au moins un entrelacement ($26_i$, $31_j$) ayant une période d'entrelacement plus longue qu'une tranche temporelle, et dans lequel on fait varier la position des symboles de substitution dans les tranches où des symboles de la séquence sont remplacés.

2. Procédé selon la revendication 1, dans lequel la production de la séquence comporte au moins un codage de canal ($23_i$) opéré avant l'entrelacement ($26_i$, $31_j$), chaque symbole numérique de la séquence ($r_j$) étant associé à au moins un symbole codé en sortie du codage de canal, et dans lequel la position des symboles de substitution d'une tranche à une autre tranche dans la période d'entrelacement est choisie de façon à disperser, en sortie du codage de canal, les symboles codés associés aux symboles remplacés par les symboles de substitution.

3. Procédé selon la revendication 1 ou 2, dans lequel la période d'entrelacement comporte au moins une trame subdivisée en un nombre déterminé de tranches temporelles successives.

**4.** Procédé selon la revendication 3, dans lequel chaque trame est subdivisée en quinze tranches temporelles successives, et dans lequel une tranche sur trois comporte un symbole de substitution.

**5.** Procédé selon la revendication 3 ou 4, dans lequel la production de la séquence comporte au moins un codage de canal ($23_i$) opéré à l'échelle de la période d'entrelacement, suivi par un premier entrelacement ($26_i$) opéré à l'échelle de la période d'entrelacement puis par un second entrelacement ($31_j$) opéré à l'échelle des trames.

**6.** Procédé selon l'une quelconque des revendications 3 à 5, dans lequel la période d'entrelacement comporte $F_i$ trames, où $F_i$ est un nombre plus grand que 1, et dans lequel la production de la séquence comporte au moins un codage de canal ($23_i$) suivi par un entrelacement inter-trame ($26_i$) qui affecte chaque symbole de position n = $(\alpha-1).F_i + \beta$ en sortie du codage de canal à une $\alpha$-ième position d'une trame de la période d'entrelacement définie par l'entier $\beta$, $\alpha$ et $\beta$ étant des entiers tels que $\alpha \geq 1$ et $1 \leq \beta \leq F_i$.

**7.** Procédé selon l'une quelconque des revendications 3 à 6, dans lequel la production de la séquence comporte un entrelacement ($31_j$) opéré à l'échelle des trames, et dans lequel chaque trame comporte avant ledit entrelacement plusieurs groupes de symboles concaténés respectivement issus de canaux de transport différents multiplexés sur ledit canal de communication, chacun desdits canaux de transport ayant une période d'entrelacement respective composée d'un nombre entier de trames.

**8.** Procédé selon l'une quelconque des revendications 3 à 7, dans lequel la production de la séquence de symboles comporte un entrelacement intra-trame ($31_j$) qui affecte chaque symbole de rang $(\alpha-1).C2 + \beta$ d'une trame d'entrée à une $(\varepsilon.R2+\alpha)$-ième position d'une $\gamma$-ième tranche de la trame, C2 étant le double du nombre de tranches par trame, R2 étant le plus petit entier tel que R2 × C2 soit au moins égal au nombre de symboles de la trame d'entrée, $\alpha$ et $\beta$ étant des entiers tels que $1 \leq \alpha \leq R2$ et $1 \leq \beta \leq C2$, $\varepsilon$ étant égal à 0 ou 1, et $\gamma$ étant un entier tel que $2.(\gamma-1) + \varepsilon$ soit obtenu en fonction de $\beta-1$ par une permutation déterminée sur les entiers compris entre 0 et C2-1.

**9.** Procédé selon l'une quelconque des revendications précédentes, dans lequel ledit canal de communication est un canal radio à étalement de spectre.

**10.** Procédé selon l'une quelconque des revendications précédentes, dans lequel certains au moins des symboles de substitution sont émis sur le canal de communication avec une puissance d'émission supérieure aux autres symboles ($r_j$) de la séquence.

**11.** Procédé selon l'une quelconque des revendications précédentes, dans lequel les symboles de substitution ont un état dans lequel ils sont émis sur le canal de communication avec une puissance d'émission sensiblement nulle.

**12.** Procédé selon l'une quelconque des revendications précédentes, dans lequel il est prévu au moins un canal de signalisation dont la lecture est optionnelle pour au moins un récepteur et ayant un intervalle de temps de transmission plus court qu'un intervalle de temps de transmission de ladite séquence de symboles numériques, et dans lequel l'information de signalisation portée par au moins un symbole de substitution commande au récepteur la lecture d'au moins un canal de signalisation sur un intervalle de temps de transmission dudit canal de signalisation.

**13.** Procédé selon la revendication 12, dans lequel il est en outre prévu au moins un canal de communication descendant partagé à haut débit ayant un intervalle de temps de transmission plus court que l'intervalle de temps de transmission de ladite séquence de symboles numériques, et dans lequel le canal de signalisation est utilisé pour transmettre des informations pour la lecture par au moins un récepteur sur un intervalle de temps de transmission dudit canal de communication descendant partagé à haut débit.

**14.** Dispositif d'émission pour un système de communication numérique, comprenant :

- des moyens (1,2) de production d'une séquence de symboles numériques ($r_j$) ;
- des moyens ($32_j$) d'affectation des symboles de la séquence à des positions respectives dans des tranches temporelles successives, conformément à un format de tranche prédéterminé ;
- des moyens de substitution (100, 108) pour remplacer, dans plusieurs des tranches temporelles, au moins un symbole de la séquence par un symbole de substitution porteur d'une information supplémentaire ; et
- des moyens (3, 4) d'émission, sur un canal de communication, d'un signal représentatif de la séquence de symboles répartie dans les tranches temporelles,

dans lequel les moyens de production de la séquence comportent au moins un entrelaceur ($26_i$, $31_j$) ayant une période d'entrelacement plus longue qu'une tranche temporelle, et dans lequel les moyens de substitution sont adaptés pour faire varier la position des symboles de substitution dans les tranches où des symboles de la séquence sont remplacés.

**15.** Dispositif d'émission selon la revendication 14, dans lequel les moyens de production de la séquence comportent au moins un codeur de canal ($23_i$), chaque symbole numérique de la séquence ($r_j$) étant associé à au moins un symbole codé en sortie du codeur de canal, et dans lequel la position des symboles de substitution d'une tranche à une autre tranche est choisie de façon à obtenir une dispersion, en sortie du codeur de canal, des symboles codés associés aux symboles remplacés par les symboles de substitution.

**16.** Dispositif d'émission selon la revendication 14 ou 15, dans lequel la période d'entrelacement comporte au moins une trame subdivisée en un nombre déterminé de tranches temporelles successives.

**17.** Dispositif d'émission selon la revendication 16, dans lequel chaque trame est subdivisée en quinze tranches temporelles successives, et dans lequel une tranche sur trois comporte un symbole de substitution.

**18.** Dispositif d'émission selon la revendication 16 ou 17, dans lequel les moyens de production de la séquence comportent au moins un codeur de canal ($23_i$) opérant à l'échelle de la période d'entrelacement, suivi par un premier entrelaceur ($26_i$) opérant à l'échelle de la période d'entrelacement puis par un second entrelaceur ($31_j$) opérant à l'échelle des trames.

**19.** Dispositif d'émission selon l'une quelconque des revendications 16 à 18, dans lequel la période d'entrelacement comporte $F_i$ trames, où $F_i$ est un nombre plus grand que 1, et dans lequel le codeur de canal ($23_i$) est suivi par un entrelaceur inter-trame qui affecte chaque symbole de position $n = (\alpha\text{-}1).F_i + \beta$ en sortie du codage de canal à une $\alpha$-ième position d'une trame de la période d'entrelacement définie par l'entier $\beta$, $\alpha$ et $\beta$ étant des entiers tels que $\alpha \geq 1$ et $1 \leq \beta \leq F_i$.

**20.** Dispositif d'émission selon l'une quelconque des revendications 16 à 19, dans lequel les moyens de production de la séquence comportent un entrelaceur ($31_j$) opérant à l'échelle des trames, et dans lequel chaque trame comporte avant ledit entrelaceur plusieurs groupes de symboles concaténés respectivement issus de canaux de transport différents multiplexés sur ledit canal de communication.

**21.** Dispositif d'émission selon la revendication 20, dans lequel les moyens de production de la séquence comportent en outre, pour chacun desdits canaux de transport, un premier entrelaceur ($26_i$)

ayant une période d'entrelacement respective composée d'un nombre entier de trames.

**22.** Dispositif d'émission selon l'une quelconque des revendications 16 à 21, dans lequel les moyens de production de la séquence comportent un entrelaceur intra-trame qui affecte chaque symbole de rang $(\alpha\text{-}1).C2 + \beta$ d'une trame d'entrée à une ($\varepsilon$. R2+$\alpha$)-ième position d'une $\gamma$-ième tranche de la trame, C2 étant le double du nombre de tranches par trame, R2 étant le plus petit entier tel que $R2 \times C2$ soit au moins égal au nombre de symboles de la trame d'entrée, $\alpha$ et $\beta$ étant des entiers tels que $1 \leq \alpha \leq R2$ et $1 \leq \beta \leq C2$, $\varepsilon$ étant égal à 0 ou 1, et $\gamma$ étant un entier tel que $2.(\gamma\text{-}1) + \varepsilon$ soit obtenu en fonction de $\beta\text{-}1$ par une permutation déterminée sur les entiers compris entre 0 et C2-1.

**23.** Dispositif d'émission selon l'une quelconque des revendications 14 à 22, dans lequel ledit canal de communication est un canal radio à étalement de spectre.

**24.** Dispositif d'émission selon l'une quelconque des revendications 14 à 23, dans lequel les moyens d'émission (3) sont adaptés pour émettre certains au moins des symboles de substitution avec une puissance d'émission supérieure aux autres symboles de la séquence ($r_j$).

**25.** Dispositif d'émission selon l'une quelconque des revendications 14 à 24, dans lequel les moyens d'émission (3) sont adaptés pour émettre des symboles de substitution ayant un état déterminé avec une puissance d'émission sensiblement nulle.

**26.** Dispositif d'émission selon l'une quelconque des revendications 14 à 25, comprenant en outre des moyens (105, 106) d'émission sur au moins un canal de signalisation dont la lecture est optionnelle pour au moins un récepteur, avec un intervalle de temps de transmission plus court qu'un intervalle de temps de transmission de ladite séquence de symboles numériques, dans lequel l'information de signalisation portée par au moins un symbole de substitution comporte une commande destinée au récepteur pour la lecture d'au moins un canal de signalisation sur un intervalle de temps de transmission dudit canal de signalisation.

**27.** Dispositif d'émission selon la revendication 26, comprenant en outre des moyens (102,103) d'émission sur au moins un canal de communication descendant partagé à haut débit ayant un intervalle de temps de transmission plus court que l'intervalle de temps de transmission de ladite séquence de symboles numériques, dans lequel les moyens (105, 106) d'émission sur le canal de signalisation sont agencés pour transmettre des informations pour la lecture par au moins un récepteur sur un intervalle de temps de transmission dudit canal de communication descendant partagé à haut débit.

28. Dispositif de réception pour un système de communication numérique, comprenant :

- des moyens de réception (91, 92), sur un canal de communication, d'un signal représentatif d'une séquence de symboles numériques (r'$_j$) répartie dans des tranches temporelles successives ;
- des moyens (110, 111) d'extraction d'information supplémentaire d'une partie seulement des tranches temporelles, par lecture d'au moins un symbole respectif porteur d'une information supplémentaire dans chacune des tranches temporelles de ladite partie ; et
- des moyens (8, 9) de traitement de la séquence de symboles privée des symboles porteurs d'information supplémentaire, les symboles traités étant obtenus en des positions définies dans les tranches temporelles conformément à un format de tranche prédéterminé,

dans lequel les moyens de traitement de la séquence comportent au moins un désentrelaceur (46$_i$, 51$_j$) ayant une période de désentrelacement plus longue qu'une tranche temporelle, et dans lequel lesdits moyens d'extraction sont adaptés pour lire lesdits symboles porteurs d'information supplémentaire en des positions variables d'une tranche à une autre tranche dans ladite partie.

29. Dispositif de réception selon la revendication 28, dans lequel les moyens de traitement de la séquence comportent au moins un décodeur de canal (43$_i$) en aval du désentrelaceur (46$_i$, 51$_j$), chaque symbole numérique de la séquence (r'$_j$) étant associé à au moins un symbole codé en entrée du décodeur de canal, et dans lequel la position des symboles porteurs d'information supplémentaire varie d'une tranche à une autre tranche dans ladite partie de façon telle qu'en entrée du décodeur de canal, les symboles codés associés aux symboles porteurs d'information supplémentaire ne soient pas groupés.

30. Dispositif de réception selon la revendication 28 ou 29, dans lequel la position dans les tranches temporelles des symboles porteurs d'information supplémentaire varie dans la période de désentrelacement selon un motif prédéfini.

31. Dispositif de réception selon la revendication 28 ou 29, comprenant en outre des moyens de réception d'une information décrivant la position des symboles porteurs d'information supplémentaire à lire sur plusieurs tranches temporelles dans la période de désentrelacement.

32. Dispositif de réception selon l'une quelconque des revendications 28 à 31, dans lequel la période de désentrelacement comporte au moins une trame subdivisée en un nombre déterminé de tranches temporelles successives.

33. Dispositif de réception selon la revendication 32, dans lequel les moyens de traitement de la séquence comportent un premier désentrelaceur (51$_j$) opérant à l'échelle des trames suivi par un second désentrelaceur (46$_i$) opérant à l'échelle de la période de désentrelacement et par un décodeur de canal (43$_i$) opérant à l'échelle de la période de désentrelacement.

34. Dispositif de réception selon la revendication 31 ou 32, dans lequel chaque trame est subdivisée en quinze tranches temporelles successives, et dans lequel une tranche sur trois comporte au moins un symbole porteur d'information supplémentaire.

35. Dispositif de réception selon l'une quelconque des revendications 32 à 34, dans lequel les moyens de traitement de la séquence comportent un désentrelaceur (51$_j$) opérant à l'échelle des trames, et des moyens de segmentation (48) pour extraire de chaque trame désentrelacée plusieurs groupes de symboles respectivement adressés à des chaînes de traitement de canaux de transport différents multiplexés sur ledit canal de communication.

36. Dispositif de réception selon la revendication 35, dans lequel chaque chaîne de traitement d'un canal de transport comporte un second désentrelaceur (46$_i$) opérant à l'échelle d'une période d'entrelacement respective affectée audit canal de transport.

37. Dispositif de réception selon l'une quelconque des 28 à 36, dans lequel ledit canal de communication est un canal radio à étalement de spectre.

38. Dispositif de réception selon l'une quelconque des revendications 28 à 37, comprenant en outre des moyens (94, 113) de réception sur au moins un canal de signalisation, avec un intervalle de temps de transmission plus court qu'un intervalle de temps de transmission de ladite séquence de symboles numériques, dans lequel les moyens de réception sur le canal de signalisation sont contrôlés, pour chaque intervalle de temps de transmission, par l'information supplémentaire portée par au moins un symbole lu par les moyens d'extraction (110, 111).

39. Dispositif de réception selon la revendication 38, comprenant en outre des moyens (95, 116) de réception sur au moins un canal de communication descendant partagé à haut débit ayant un intervalle de temps de transmission plus court que l'intervalle de temps de transmission de ladite séquence de symboles numériques, dans lequel les moyens de réception sur le canal de communication descendant partagé à haut débit sont contrôlés, pour chaque intervalle de temps de transmission, par de l'information de signalisation lue sur ledit canal de signalisation en fonction de l'information supplémentaire portée par au moins un symbole lu par les moyens d'extraction.

EP 1 324 500 A1

1 TRAME
(10ms)

| #0 | #1 | #2 | | | | | | | | | | | | #14 |

1 TIMES LOT
(666 µs)

| DATA 1 | TPC | TFCi | DATA 2 | PL |

FIG.1.

FIG.2.

FIG.3.

$a_i$

20 $i$

21$i$ — AJOUT CRC

20 $_{i+1}$

$\downarrow a_{i+1}$

$b_i$

22$i$ — CONCATÉNATION TrBk/ SEGM. BLOCS DE CODE

$o_i$

23$i$ — CODAGE CANAL

$c_i$

24 $_{i+1}$

24$i$ — ADAPTATION DÉBIT

ADAPTATION DÉBIT

...

$g_i$

25$i$ — INSERTION BITS DTX (POSITIONS FIXES)

$h_i$

26$i$ — ENTRELACEMENT INTER-TRAME

$q_i$

27$i$ — SEGMENTATION TRAMES RADIO/TTI

$f_i$ ... $f_{i+1}$

28 — MULTIPLEXAGE TrCH

$s$

29 — INSERTION BITS DTX (POSITIONS VARIABLES)

$w$

30 — SEGMENTATION PAR PhCH

$u_j$ $u_{j+1}$ ...

31$j$ — ENTRELACEMENT INTRA-TRAME — 31 $j_{+1}$

...

$v_j$ $v_{j+1}$

32$j$ — REMPLISSAGE CANAUX PHYSIQUES — 32 $j_{+1}$

...

$r_j$ $r_{j+1}$ ...

PhCH # PhCH # ...

FIG.4.

$r'_j$  $r'_{j+1}$

$52_j$ —— | EXTRACTION DPDCH | —— $52_{j+1}$

$v'_j$  $v'_{j+1}$ ...

$51_j$ —— | DÉSENTRELACEMENT INTRA-TRAME | —— $51_{j+1}$

$u'_j$  $u'_{j+1}$ ...

$50$ —— | MULTIPLEXAGE PhCH |

$w'$

$49$ —— | SUPPRESSION BITS DTX (POSITIONS VARIABLES) |

FIG.5.

$s'$

$48$ —— | SEGMENTATION PAR TrCH |

$f'_i$  ...  $f'_{i+1}$  $40_{i+1}$

$40_i$

$47_i$ —— | CONCATÉNATION TRAMES RADIO / TTI |

$q'_i$

$46_i$ —— | DÉSENTRELACEMENT INTER-TRAME |

$h'_i$

$45_i$ —— | SUPPRESSION BITS DTX (POSITIONS FIXES) |

$g'_i$

$44_i$ —— | ADAPTATION DÉBIT |

$c'_i$

$43_i$ —— | DÉCODAGE CANAL |

$o'_i$

$42_i$ —— | CONCATÉNATION BLOCS DE CODE /SEGMENTATION PAR TrBk |

$b'_i$

$41_i$ —— | VÉRIFICATION CRC |

$a'_i$  $a'_{i+1}$

FIG.6.

BLOC DE TRANSPORT CODÉ

| A₁ | A₂ | A₃ | . . . | A₂₉₄ |

60

1ᵉʳ ENTRELACEMENT

61

| A₁ |
| A₃ |
| A₅ |
| A₇ |
| ⋮ |
| A₂₉₃ |

| A₂ |
| A₄ |
| A₆ |
| A₈ |
| ⋮ |
| A₂₉₄ |

SEGMENTATION EN TRAMES

| Ⓐ₁ | A₃ | A₅ | A₇ | . . . |

62

| Ⓐ₂ | A₄ | A₆ | A₈ | . . . |

2ᵉ ENTRELACEMENT

| A₁₁₅ | A₇₇ | A₂₆₁ | Ⓐ₁ | . . . |

63

| A₁₁₆ | A₇₈ | A₂₆₂ | Ⓐ₂ | . . . |

EP 1 324 500 A1

FIG.7.

EP 1 324 500 A1

| n° TRANCHE / n°TRAME | 0 | 1 | 2 | 3 | 4 | 5 | 6 | 7 | 8 | 9 | 10 | 11 | 12 | 13 | 14 |
|---|---|---|---|---|---|---|---|---|---|---|---|---|---|---|---|
| 0 | 0 | | | 3 | | | 6 | | | 9 | | | 12 | | |
| 1 | 3 | | | 6 | | | 9 | | | 12 | | | 0 | | |
| 2 | 6 | | | 9 | | | 12 | | | 0 | | | 3 | | |
| 3 | 9 | | | 12 | | | 0 | | | 3 | | | 6 | | |

FIG.8.

| n° TRANCHE / n°TRAME | 0 | 1 | 2 | 3 | 4 | 5 | 6 | 7 | 8 | 9 | 10 | 11 | 12 | 13 | 14 |
|---|---|---|---|---|---|---|---|---|---|---|---|---|---|---|---|
| 0 | 0 | | | 3 | | | 6 | | | 9 | | | 12 | | |
| 1 | 1 | | | 4 | | | 7 | | | 10 | | | 13 | | |
| 2 | 2 | | | 5 | | | 8 | | | 11 | | | 14 | | |
| 3 | 3 | | | 6 | | | 9 | | | 12 | | | 15 | | |

FIG.9.

# EP 1 324 500 A1

**Office européen des brevets**

## RAPPORT DE RECHERCHE EUROPEENNE

**Numéro de la demande**

EP 02 29 3185

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 309 474 A (GILHOUSEN KLEIN S ET AL) 3 mai 1994 (1994-05-03) | 1-3,9, 10, 14-16, 23,24, 28-32,37 | H03M13/27 |
| | * colonne 19, ligne 41 - ligne 68 * <br> * colonne 23, ligne 8 - ligne 13 * | | |
| Y | * colonne 24, ligne 7 - ligne 29 * | 5,7,18, 20,21, 33,35,36 | |
| | * colonne 34, ligne 62 - colonne 35, ligne 2 * <br> * colonne 35, ligne 48 - ligne 65 * <br> --- | | |
| Y | EP 1 100 204 A (NTT DOCOMO INC) 16 mai 2001 (2001-05-16) | 5,7,18, 20,21, 33,35,36 | |
| | * colonne 10, ligne 7 - ligne 39 * <br> * colonne 11, ligne 6 - ligne 25 * | | |
| A | * colonne 12, ligne 23 - ligne 25 * | 1,4,14, 17,28,34 | |

**DOMAINES TECHNIQUES RECHERCHES (Int.Cl.7)**

H03M
H04L

* colonne 13, ligne 27 - ligne 37 *
* colonne 17, ligne 20 - ligne 24 *
* colonne 17, ligne 53 - colonne 18, ligne 4 *

---

-/--

Le présent rapport a été établi pour toutes les revendications

| Lieu de la recherche | Date d'achèvement de la recherche | Examinateur |
|---|---|---|
| LA HAYE | 6 février 2003 | Papantoniou, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

**RAPPORT DE RECHERCHE EUROPEENNE**

Numéro de la demande

EP 02 29 3185

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | VALENTI M C ET AL: "A bandwidth efficient pilot symbol technique for coherent detection of turbo codes over fading channels" MILITARY COMMUNICATIONS CONFERENCE PROCEEDINGS, 1999. MILCOM 1999. IEEE ATLANTIC CITY, NJ, USA 31 OCT.-3 NOV. 1999, PISCATAWAY, NJ, USA,IEEE, US, 31 octobre 1999 (1999-10-31), pages 81-85, XP010369653 ISBN: 0-7803-5538-5 * page 82, colonne de gauche, alinéa 2 * * page 82, colonne de gauche, alinéa 4; figure 1 * | 1,14,28 | |
| A | WO 01 01626 A (SAMSUNG ELECTRONICS CO LTD) 4 janvier 2001 (2001-01-04) * page 8, ligne 17 - ligne 24 * * page 10, ligne 10 - ligne 13 * * page 16, ligne 36 - page 17, ligne 19 * | 1,14,28 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| LA HAYE | 6 février 2003 | Papantoniou, A |

**ANNEXE AU RAPPORT DE RECHERCHE EUROPEENNE
RELATIF A LA DEMANDE DE BREVET EUROPEEN NO.**　　　　EP 02 29 3185

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-02-2003

| Document brevet cité au rapport de recherche | Date de publication | Membre(s) de la famille de brevet(s) | | Date de publication |
|---|---|---|---|---|
| US 5309474 A | 03-05-1994 | US | 5103459 A | 07-04-1992 |
| | | US | 5715236 A | 03-02-1998 |
| | | AT | 218020 T | 15-06-2002 |
| | | AU | 652956 B2 | 15-09-1994 |
| | | AU | 8401691 A | 23-01-1992 |
| | | BG | 61514 B1 | 31-10-1997 |
| | | BG | 97222 A | 27-05-1994 |
| | | BR | 9106592 A | 08-06-1993 |
| | | CA | 2085890 A1 | 26-12-1991 |
| | | CA | 2360909 A1 | 09-01-1992 |
| | | CN | 1061312 A ,B | 20-05-1992 |
| | | CZ | 283123 B6 | 14-01-1998 |
| | | CZ | 9203871 A3 | 17-11-1993 |
| | | DE | 69133017 D1 | 27-06-2002 |
| | | DE | 69133017 T2 | 06-02-2003 |
| | | DK | 536334 T3 | 09-09-2002 |
| | | EP | 1104955 A1 | 06-06-2001 |
| | | EP | 0536334 A1 | 14-04-1993 |
| | | ES | 2174823 T3 | 16-11-2002 |
| | | FI | 925812 A | 21-12-1992 |
| | | HU | 216989 B | 28-10-1999 |
| | | HU | 64657 A2 | 28-01-1994 |
| | | IL | 98598 A | 27-02-1994 |
| | | JP | 3357620 B2 | 16-12-2002 |
| | | JP | 11317691 A | 16-11-1999 |
| | | JP | 2958433 B2 | 06-10-1999 |
| | | JP | 6501349 T | 10-02-1994 |
| | | KR | 134390 B1 | 27-04-1998 |
| | | MX | 173818 B | 29-03-1994 |
| | | NO | 925019 A | 23-12-1992 |
| | | PT | 98079 A ,B | 31-08-1993 |
| | | RU | 2125344 C1 | 20-01-1999 |
| | | SG | 52735 A1 | 28-09-1998 |
| | | SK | 387192 A3 | 10-08-1994 |
| | | WO | 9200639 A1 | 09-01-1992 |
| | | US | 5511073 A | 23-04-1996 |
| | | US | 5504773 A | 02-04-1996 |
| | | US | 5659569 A | 19-08-1997 |
| | | US | 5535239 A | 09-07-1996 |
| | | US | 5629955 A | 13-05-1997 |
| | | US | 5568483 A | 22-10-1996 |
| | | US | 5841806 A | 24-11-1998 |
| | | US | 5943361 A | 24-08-1999 |
| | | US | 5416797 A | 16-05-1995 |
| | | ZA | 9104847 A | 29-04-1992 |

EPO FORM P0480

Pour tout renseignement concernant cette annexe : voir Journal Officiel de l'Office européen des brevets, No.12/82

EP 1 324 500 A1

## ANNEXE AU RAPPORT DE RECHERCHE EUROPEENNE
## RELATIF A LA DEMANDE DE BREVET EUROPEEN NO.

EP 02 29 3185

06-02-2003

| Document brevet cité au rapport de recherche | | Date de publication | Membre(s) de la famille de brevet(s) | | Date de publication |
|---|---|---|---|---|---|
| EP 1100204 | A | 16-05-2001 | AU | 749821 B2 | 04-07-2002 |
| | | | AU | 4146100 A | 21-11-2000 |
| | | | CA | 2336820 A1 | 16-11-2000 |
| | | | EP | 1100204 A1 | 16-05-2001 |
| | | | CN | 1304581 T | 18-07-2001 |
| | | | WO | 0069079 A1 | 16-11-2000 |
| WO 0101626 | A | 04-01-2001 | AU | 5575400 A | 31-01-2001 |
| | | | BR | 0006859 A | 10-07-2001 |
| | | | CA | 2340254 A1 | 04-01-2001 |
| | | | CN | 1315095 T | 26-09-2001 |
| | | | EP | 1108307 A1 | 20-06-2001 |
| | | | WO | 0101626 A1 | 04-01-2001 |
| | | | KR | 2001007532 A | 26-01-2001 |
| | | | PL | 346341 A1 | 11-02-2002 |

EPO FORM P0460